# EUROPEAN PATENT SPECIFICATION

(11) **EP 3 836 529 B1**
(45) Date of publication and mention of the grant of the patent: **05.11.2025**
(21) Application number: 19383100.5
(22) Date of filing: 11.12.2019
(51) Int. Cl.: B60R 11/04, H05K 1/02, H04N 23/52

(54) **VEHICLE IMAGING DEVICE**
FAHRZEUGBILDGEBUNGSVORRICHTUNG
DISPOSITIF D'IMAGERIE DE VÉHICULE

(43) Date of publication of application: 16.06.2021
(73) Proprietor: Ficosa Adas, S.L.U., 08028 Barcelona (ES)
(72) Inventor: MARROQUÍN, Humberto, 08232 Viladecavalls (ES); GARCÍA PEDRO, Alberto Juan, 08232 Viladecavalls (ES)
(74) Representative: Elzaburu S.L.P.

(56) References cited:
- GB-A- 2 559 195
- US-A1- 2017 310 863
- US-A1- 2019 143 907

## Description

### Field of the invention

The present invention relates to an imaging device for a vehicle, specifically a motor vehicle.

The vehicle imaging device object of the invention improves the drawbacks derived from electromagnetic interference among the elements of the device.

### Background of the invention

Known imaging devices, for instance camera devices for a vehicle, comprise the following elements:
- a housing comprising an inner cavity enclosing some of the elements of the imaging device. Usually, the camera housing comprises a first part or front housing and a second part or back housing, being both parts in electrical contact between them,
- a lens usually partially located outside the front housing,
- an image sensor in communication with the lens and located in the housing,
- a printed circuit board (PCB) located in the housing and connected to the image sensor,
- a pin comprising a ground connection and in electrical contact with the printed circuit board. Pins are configured to transmit data from the printed circuit board to the exterior of the imaging device, for instance, to a connector in a vehicle. Optionally, the pins or pin may be placed on or received by an adapter.
- optionally, a connector, in connection with the PCB, suitable to receive the pins or pin of the adapter and to guide it/them towards the printed circuit board.

It is known in the state of the art that every electric charge generates an electric field around it. When the charge has movement it also creates a magnetic field, so that electric and magnetic fields coexist in the vicinity of an electric current conductor. If the circulating current is continuous, both fields are static, that is to say, their intensity does not change over time.

Printed Circuit Boards (PCBs) include a conductor loop that has self-induction, which causes a magnetic field that inherently accompanies any current. In particular, said magnetic field manifests itself when a step voltage change is applied to the input terminals of the loop. Initially, the loop generates a voltage proportional to the change in magnetic flux. This prevents the current from following the voltage step immediately. This is described by Faraday's Law. The duration of this transient voltage depends on the area of the loop. Induction can be used to delay current change. It is known that it causes undesirable electromagnetic fields.

Therefore, it is an object of the present invention to reduce or remove the electromagnetic waves within an imaging device, overcoming the above-mentioned problems of the prior art.

It is known document US2019/143907A1 disclosing a vehicular camera assembly including a front housing portion accommodating a lens, a circuit board having an imager and an electrical connecting element at opposite sides thereof, a rear housing portion and an electrical connector. The rear housing portion includes a rear attachment portion that has an aperture therethrough. The electrical connector electrically connects a wire of the vehicle to the electrical connecting element of the circuit board. The electrical connector includes an electrically conductive element that is electrically conductively connected to an outer ground contact of the connector. The rear housing portion includes a shield element having flexible tabs that protrude through the aperture. As the electrical connector is attached at the rear attachment portion, the shield element tabs engage the electrically conductive element to establish and maintain electrically conductive connection between the shield element and the electrically conductive element and the outer ground contact of the connector. Further examples for vehicular camera assemblies can be found in US2017/310863A1 and GB2559195A.

### Summary of the invention

It is an object of the present invention a vehicle imaging device according to claim 1 for capturing images comprising:
- an image sensor configured for capturing an image,
- a lens in communication with the image sensor and configured for guiding a light beam into the image sensor,
- a printed circuit board in connection with the image sensor for receiving data from said image sensor,
- a pin comprising a ground connection and in electrical connection with the printed circuit board,
- a housing comprising an inner cavity enclosing at least the printed circuit board, the image sensor and a portion of the pin comprising a ground connection, wherein the housing is in electrical connection with the printed circuit board,
- an electrically conductive element located in electrical connection with the pin comprising a ground connection, the electrically conductive element being in electrical contact with the housing such that a closed electrical loop is formed among the printed circuit board, the pin comprising a ground connection, the electrically conductive element, the housing and the printed circuit board.

The present invention provides, therefore, an electrically conductive element located in electrical connection with the pin comprising a ground connection wherein the electrically conductive element further comprises an electrically conducting connection contacting the housing. Said electrical connection between the electrically conductive element and the housing may be, for instance, an electrical wire or a metallic sheet with an appropriate shape.

The connection of the electrically conductive element with the housing may be performed connecting the electrically conductive element with the inner cavity of the housing or with other part of the housing, for instance, the rear part of the back housing.

Thus, the object of the above technical features is to provide an element that electrically connects the pin comprising a ground connection with the housing in order to minimise undesirable electromagnetic effects.

The imaging device has a plurality of pins, some of them configured for transmitting data and at least one configured for being connected to ground. In another alternative a pin may comprise, for instance, a first longitudinal portion of the pin configured for transmitting data and a second longitudinal portion of said pin configured for being connected to ground. Both longitudinal portions may be, for example, concentric.

The pin or plurality of pins may have their ends in contact with the printed circuit board or alternatively, the pin or plurality of pins are attached to the printed circuit board and their ends leave the housing.

According to the above, the electrically conductive element is in electrical contact with said pin and is, for instance, made of a conductive material (e.g. metal, steel or aluminium).

As previously stated, the electromagnetic effect is reduced as the circuit loop is closed through the following elements:
The printed circuit board which is in electrical connection with the pin comprising a ground connection, which is in electrical contact with the electrically conductive element, which is in electrical contact with the housing and being the housing in electrical contact with the printed circuit board.

The invention provides an element or component easy to manufacture and to install that reduces the electromagnetic effect of the vehicle's imaging device. The invention further accomplishes this by including a few and simple components.

### Description of the figures

To complete the description and in order to provide for a better understanding of the invention, drawings are provided. Said drawings form an integral part of the description and illustrate a preferred embodiment of the invention. The drawings comprise the following figures.
Figure 1 shows a longitudinal cross-section of an imaging device known in the state of the art having a first and a second printed circuit board.
Figure 2 shows a longitudinal cross-section of an imaging device according to an embodiment of the invention.
Figure 3 shows a perspective view of an embodiment of an adapter and of an electrically conductive element.
Figures 4 show perspective views of the embodiment of the adapter corresponding to figure 3 and different embodiments of the electrically conductive element.
Figure 5 shows a plan view of the adapter of figure 3 in a first embodiment.
Figure 6 shows a plan view of the adapter of figure 3 in a second embodiment.
Figure 7 is a longitudinal cross-section of an embodiment the imaging device showing an embodiment of the electrically conductive element.

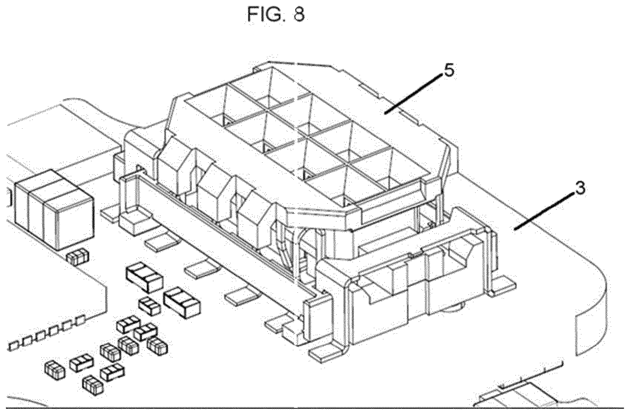

Figure 8 is a perspective view of an embodiment of a connector that comprises a plurality of orifices for receiving and guiding the pins for contacting the printed circuit board.

### Detailed description of the invention

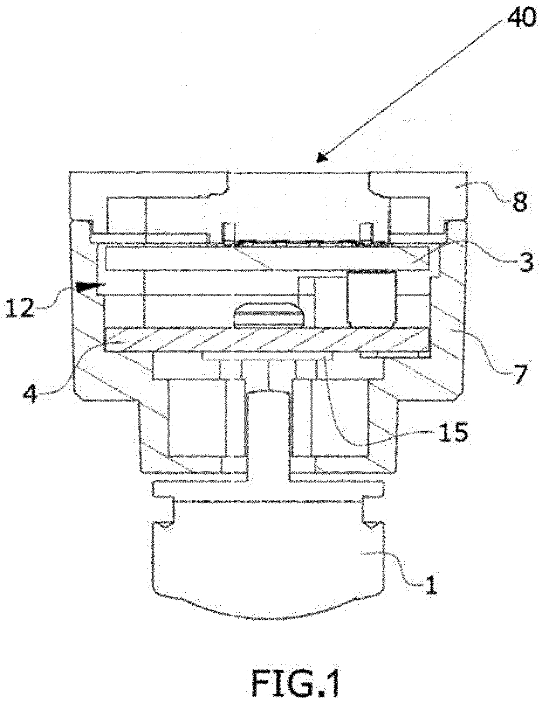

Figure 1 shows an imaging device, specifically, a camera module known in the state of the art. It comprises a housing (7, 8), the housing (7, 8) comprising a first part (7) or front housing, and a second part (8) or back housing, wherein both first part (7) and second part (8) are in electrical contact and joined, for instance, by means of a weld or fasteners, for instance, screws.

The housing (7, 8) must necessarily be conductive or contain a conductive line/surface.

Preferably, the two parts of the housing (7, 8) are metallic, specifically made of aluminium. Other alternative is that both parts (7, 8) are made of a composite material, for instance comprising carbon fibre and metallic particles. Another alternative would be having a plastic housing (7, 8) comprising in its inner cavity (12) a conductive box, for instance, metallic or a conductive shield.

The housing (7, 8) comprises an inner cavity (12) accommodating a plurality of components. Figure 1 shows a lens (1) partially located in the front housing (7) that guides / directs / projects a light beam from outside to the image sensor (15).

In the prior art shown in figure 1, two printed circuit boards (3, 4) are included being located such that a gap between the first PCB (3) and the second PCB (4) exists preventing electric current to drive through. The second printed circuit board (4) is connected to the first printed circuit board (3), while the image sensor (15) is disposed thereat the second printed circuit board PCB (4).

According to the state of the art shown in figure 1, the image sensor (15) is mounted on the second printed circuit board PCB (4). The image sensor (15) is the element of an electronic camera which detects and captures the information that makes up the image. This is achieved by converting the attenuation of light waves (electromagnetic radiation) into electrical signals. It is a chip made up of millions of light-sensitive components (photodiodes or phototransistors) that, when exposed, capture the projected waves of a lens (1), which composes the image. The image sensor (15) is aligned with the lens (1).

The first printed circuit board PCB (3) may include an Electronic Control Unit (ECU), in particular, the ECU is an Image Signal Processor (ISP). The ISP receives the electrical signal corresponding to the image generated by the image sensor (15). The first circuit board PCB (3) processes the captured image. Preferably, the first printed circuit board PCB (3) and the second printed circuit board PCB (4) are parallel.

As can be seen in figure 1, the surface of the first printed circuit board PCB (3) opposite to the second PCB (4) is in contact with the pins (21, 21.1) transmitting information with the first printed circuit board PCB (3).

The housing (7, 8) comprises an opening (40) configured for the passage of at least the pin (21.1) comprising a ground connection out of the cavity (12) of the housing (7, 8) and, in the shown embodiment, also the data pins (21).

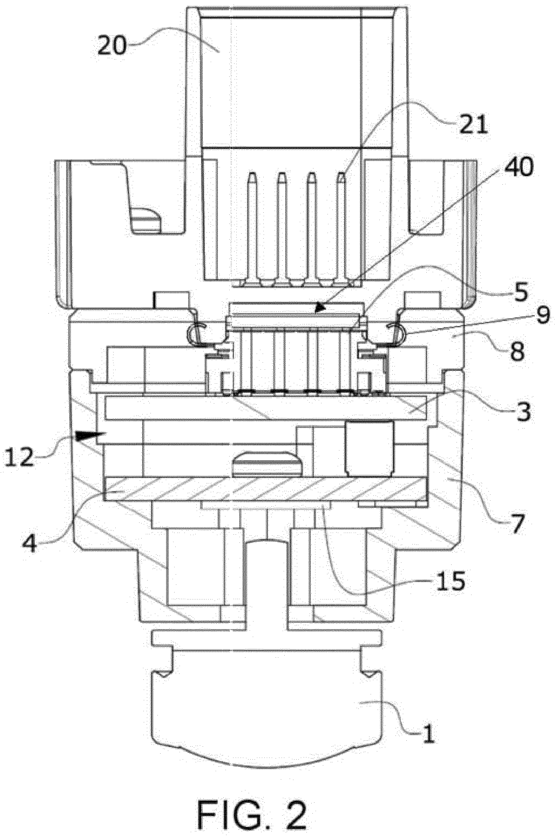

Figure 2 shows that the imaging device comprises a plurality of pins (21, 21.1) that transmit data whose ends are in contact with the printed circuit board (3). The function of these pins (21, 21.1) is to transmit data to and from the printed circuit board PCB (3) which, in turn, will exit the housing (7, 8).

In particular, the shown imaging device comprises eight pins (21, 21.1) that may be adapted to:
(i) power supply (current);
(ii) data transmission (image transfer);
(iii) connection to the vehicle CAN-BUS or Ethernet, etc.

In the embodiments shown in the figures, seven pins (21) are for transmitting data and one pin (21.1) is a ground pin.

The electrically conductive element (30) is electrically connected to the pin (21.1) comprising a ground connection or ground pin (21.1). The electrically conductive element (30) is not connected to data pins (21). Additionally, in order to avoid the contact of a data pin (21) and the electrically conductive element (30), the data pin (21) may comprise an isolating means surrounding the data pin (21), for instance, a rubber ring.

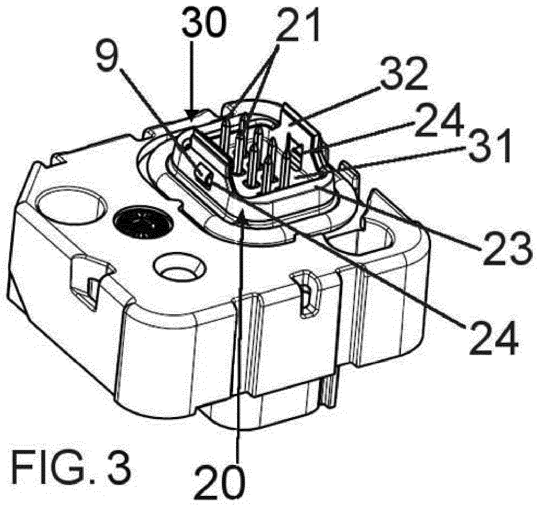

As previously stated, figures 2 and 3 shows eight pins (21, 21.1) that are preferably made of a conductive material and more preferably made of aluminium, copper or brass.

The shown embodiment also comprises a connector (5) in connection with the printed circuit board (3). The connector (5) is in electrical contact with the pin (21.1) comprising a ground connection. The connector (5) further comprises a plurality of orifices for receiving and guiding the pins (21, 21.1) for contacting the printed circuit board (3).

Due to existing tolerances, it is difficult to have the pins (21, 21.1) make contact with the PCB (3). The connector (5) disposed thereat the PCB (3) acts as a guide for the pins (21, 21.1) as its purpose is to receive the pins (21, 21.1) and to ensure their contact with the PCB (3). The connector (5) may have a lateral movement, for instance, of 0.4 mm in each direction, to receive the pins (21, 21.1) and to ensure their electrical contact with the PCB (3).

The connector (5) may additionally comprise elastic conductive elements having two ends, one end contacts with the orifices of the connector (5) and the other end contacts with the PCB (3) tracks. These conductive elements, on the one hand, assure the electrical contact of the pins (21, 21.1) with the PCB (3) and, on the other hand, in being elastic and deformable, they deform allowing the movement of 0.4 mm in each direction.

In the embodiment of figure 2 the imaging device also shows an adapter (20). The adapter (20) comprises at least the pin (21.1) comprising a ground connection and, in the shown embodiment, the data pins (21). The adapter (20) is configured to fit into the opening (40) of the housing (7, 8).

The outer surface of the back housing (8) is in contact with the adapter (20) and a portion of the adapter (20) is enclosed by the inner cavity of the back housing (8). In particular, the adapter (20) has a plurality of pins (21, 21.1) that are received by a plurality of orifices of the connector (5).

The electrically conductive element (30) may be part of the adapter (20), or alternatively, may be attached to the adapter (20) such that the electrically conductive element (30) is received within the adapter (20).

Figure 3 shows an embodiment of the electrically conductive element (30). The electrically conductive element (30) comprises a projection (9), the projection (9) being located such that it is able to contact the inner cavity (12) of the housing (7, 8).

The projection (9) and the electrically conductive element (30) may be separated or single components.

The inclination, length and, in general, the geometry of the projection (9) is such that it allows contact with any part of the housing (7, 8). For instance, on any surface (13, 14) of the inner cavity (12) as long as it is conductive.

In the embodiment shown in figure 3, two opposing projections (9) are shown, said projections (9) comprising a rounded shape.

Preferably, the projection (9) is flexible and is configured to be bent to adapt its position to contact the housing (7, 8). More preferably, the projection (9) is an elastic spring configured for being elastically deformed. The deformation direction is appreciably perpendicular to the longitudinal axis of the camera (optical axis of the camera), i.e., to the pins (21, 21.1).

In the embodiment, the electrically conductive element comprises two projections (9) diametrically opposed. The projections (9) are flexible, i.e., deforms or bents without breaking and are adapted to be bent to vary their position to contact the housing (1, 2), which means that they are resilient acting as a biasing means adapted to accommodate different manufacturing tolerances.

In an embodiment, the electrically conductive element (30) is located such that it at least partially covers or partially spreads over the opening (40) of the housing (7, 8).

The electrically conductive element (30) may be a planar or curved surface element located such that at least partially covers the opening (40). Surface element means in the description a plane or curved two-dimensional element. In an embodiment, the surface element may be a plate (31). More specifically the conductive element is not an electrical wire, as a wire is understood as one-dimensional element.

The conductive element (30) may have a shape corresponding to the shape of the opening (40) such that it spreads over the opening (40).

One advantage of the electrically conductive element (30) partially covering the opening (40) is that it improves the electromagnetic compatibility as the electrically conductive element (30) acts like a Faraday shield that blocks electromagnetic fields. According to one example, the surface element, for instance a plate (31), may have an area equal to or greater than 30% of the area of the opening (40) of the housing (7, 8). According to another example, the surface element may have an area of at least 50% of the area of the opening (40) of the housing (7, 8).

Figure 3 shows the adapter (20) and the electrically conductive element (30). The electrically conductive element (30) is mounted on the adapter (20). In particular, the electrically conductive element (30) is located within the adapter (20).

In the shown embodiment, the electrically conductive element (30) comprises an electrically conductive plate (31) located perpendicular to the longitudinal axis of the imaging device, i.e., perpendicular to the pin (21.1) comprising a ground connection and/or to the pins (21, 21.1). It also comprises a lateral wall (32) that extends substantially perpendicular to said plate (31) wherein the projection (9) extends outwardly from said lateral walls (32). The projections (9) are additionally located at two different opposite sides of the base (31).

One advantage of the electrically conductive element (30) comprising a plate (31) is that it improves the electromagnetic compatibility as the plate (31) acts like a Faraday shield that blocks electromagnetic fields.

The adapter (20) comprises a surface (22) substantially perpendicular to the longitudinal axis of the vehicle imaging device, i.e., substantially perpendicular to the pin (21.1) comprising a ground connection and/or to the pins (21, 21.1) and a lateral wall (23) that extends substantially perpendicular to said surface (22).

Additionally, the electrically conductive plate (31) extends until the lateral walls (22) of the adapter (20) substantially covering the surface (22). Thus, the plate (31) fits inside the adapter (20), i.e. the size and geometry are substantially equal to the surface (22) of the adapter (20).

As previously stated, one advantage of said configuration is that it improves the electromagnetic compatibility as the plate (31) acts like a Faraday shield that blocks electromagnetic fields. Additionally, any undesirable external force, instead of being absorbed by the pin (21.1), is absorbed by the lateral wall (23) of the adapter (20).

According to the embodiment of figure 3, the lateral wall (23) of the adapter (20) comprises an opening (24). The projections (9) are adapted to go through said openings (23) so as to contact the inner surface of the housing (7, 8).

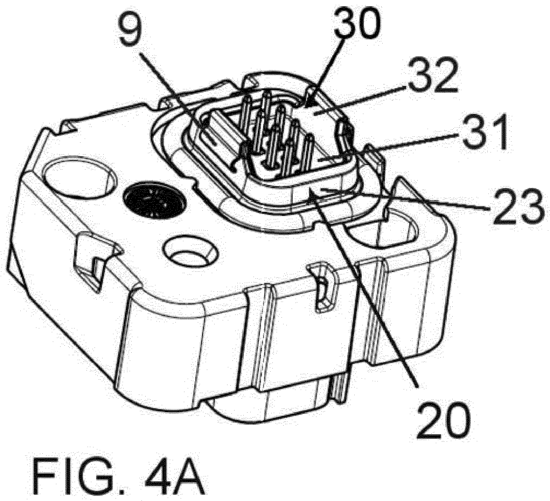

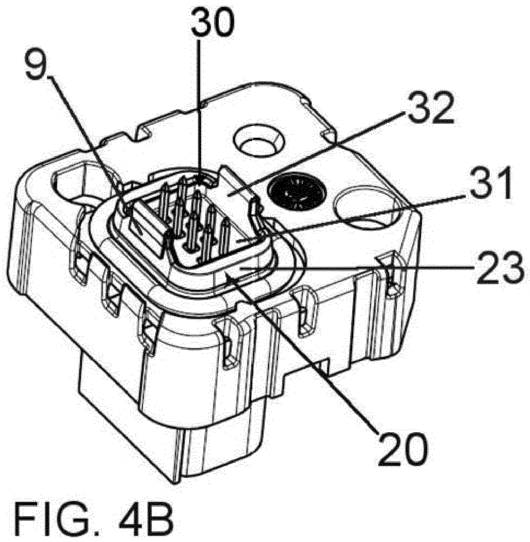

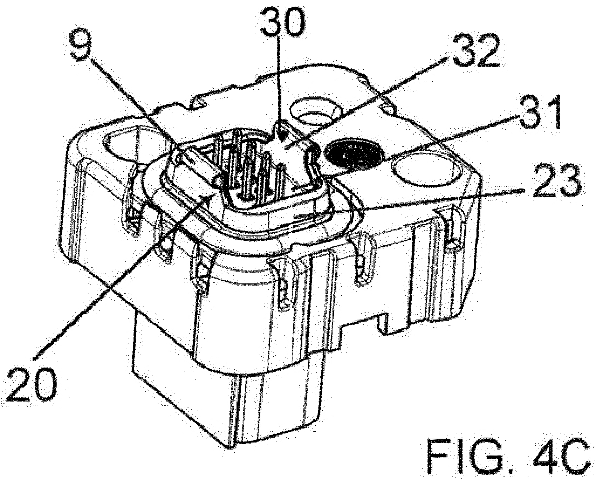

Figures 4 show other embodiments, where the adapter (20) has no openings (24) on the lateral wall (23). Therefore, the projection (9) does not leave through an opening (24) to contact the housing (7, 8). According to the shown embodiments, the electrically conductive element (30) extends above the lateral wall (23) of the adapter (20), surpassing the lateral wall (23) free edge of the adapter (20). The projection (9) is located between the housing (7, 8) and the outer face of the side wall (22) of the adapter (20).

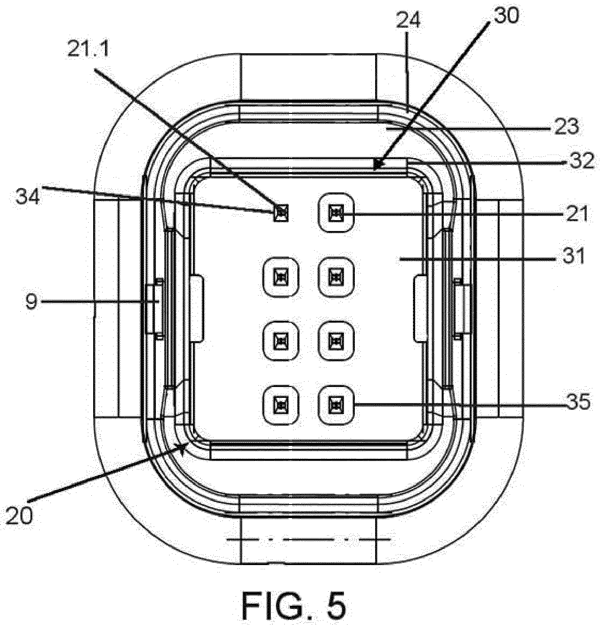

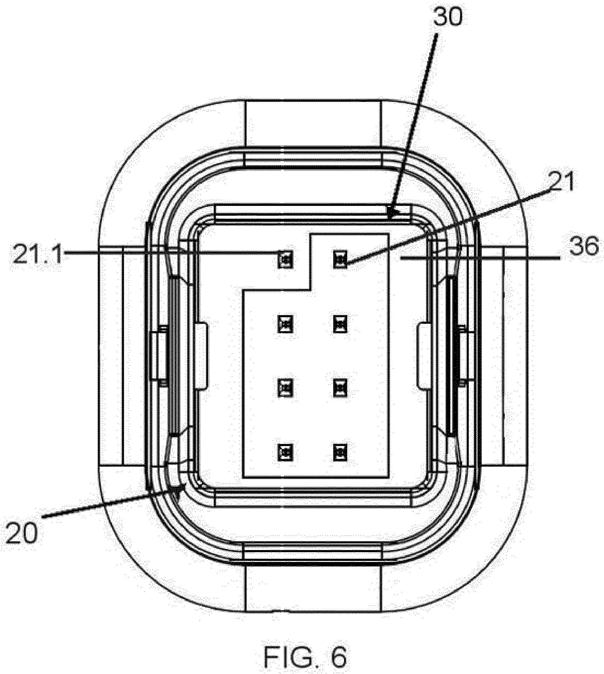

Figures 5 and 6 disclose two embodiments of the electrical connection between the electrically conductive element (30) and the pin (21.1) comprising the ground connection.

There must be an electrical connection between the projection (9) and, for instance, the ground pin (21.1), either through a wire (not shown in the figures) or through the aforementioned plate (31) shown in figures 5 and 6.

The plate (31) is an electrically conductive surface, in an embodiment, a flat surface. In the shown embodiment, the plate (31) comprises a plurality of orifices (34, 35) from where the pins (21, 21.1) come out.

Figure 5 shows an embodiment of the connection between the plate (31) of the electrically conductive element (30) and the ground pin (21.1).

The plate (31) of the electrically conductive element (30) comprises an orifice (34) where the ground pin (21.1) comes out, the orifice (34) being in electrical contact with the ground pin (21.1).

In figures 5 and 6, the adapter (20) comprises a plurality of pins (21, 21.1). In the embodiment shown in figure 5 the plate (31) of the electrically conductive element (30) comprises a plurality of orifices (34, 35), one for each pin (21, 21.1). The orifice (34) for the ground pin (21.1) is in electrical contact with the pin (21.1) and the rest rests of the orifices (35) are not in contact with the pins (21). Additionally, the plate (31) may comprise isolating elements located in the orifices (35) in order to avoid any contact of the plate (31) with the data transmitting pins (21).

In another embodiment shown in figure 6, the plate (31) comprises an orifice (36) where the rest of the pins (21) different from the ground pin (21.1) come out. The advantage of this embodiment is that the device is suitable for several kinds of cameras, regardless of the camera supplier.

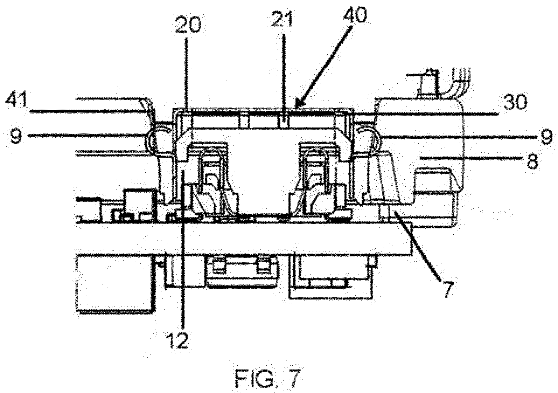

Figure 7 is a cross-section where the contact between the projection (9) and the back housing (8) is shown. In particular, the back housing (8) has an opening (40) through which the adapter (20) passes. The projections (9) contact, in particular, the lateral walls (41) of the opening (40). This has the advantage that once the adapter (20) is introduced through the opening (40), the projections (9) easily get contact with the housing (7, 8). Additionally, the shown adapter (20) is connected to the connector (5).

The printed circuit board (3, 4) and the housing (7, 8) are electrically in contact by, for instance, the following means, among others:
- A conductive glue, or
- A gasket made of an electrically conductive material, or
- Metallic or conductive screws that pass through the PCB (3, 4) and contact the housing (7, 8).

If the embodiment comprises a single PCB (3), the above contact is made between said PCB (3) and, for instance, the front housing (7), thus the conductive glue or screws are located in said PCB (3). In an embodiment comprising two PCBs (3, 4), the above-mentioned contact is frequently made between the second PCB (4) and the front housing (7) and therefore, the conductive glue or screws would be located in said second PCB (4) to make contact with the mentioned front housing (7).

In addition, the edges of the PCB (3) are coated with a conductive material, for example, copper.

In an embodiment with two PCBs (3, 4), both PCBs (3, 4) are connected to each other through a board-to-board device or through a flex.

The first printed circuit board (3) and the second printed circuit board (4) work with different intensities and voltages. According to one example, they work at approximately 5 V. According to one example, the distance between the two printed circuit boards PCBs (3, 4) is between 1 mm and 10 mm. More particularly, between 3 mm and 6 mm and more specifically is 3.5 mm. These potential differences generate undesirable electromagnetic fluxes.

According to an embodiment of the camera device, the range of the electromagnetic field varies between 50 GHz and 1500 GHz.

The invention is defined by the appended claims.

## Claims

1. Vehicle imaging device, comprising:
• an image sensor (15) configured for capturing an image,
• a lens (1) in communication with the image sensor (15) and configured for guiding a light beam into the image sensor (15),
• a printed circuit board (3) in connection with the image sensor (15),
• a pin (21.1) comprising a ground connection and in electrical connection with the printed circuit board (3),
• a housing (7, 8) comprising an inner cavity (12) enclosing at least the printed circuit board (3), the image sensor (15) and a portion of the pin (21.1) comprising a ground connection, wherein the housing (7, 8) is in electrical connection with the printed circuit board (3),
• an electrically conductive element (30) located in electrical connection with the pin (21.1) comprising a ground connection, the electrically conductive element (30) being in electrical contact with the housing (7, 8) such that a closed electrical loop is formed among the printed circuit board (3), the pin (21.1) comprising a ground connection, the electrically conductive element (30), the housing (7, 8) and the printed circuit board (3), and
• an adapter (20), the adapter (20) at least comprising a plurality of pins (21) including the pin (21.1) comprising a ground connection, the electrically conductive element (30) being part of or attached to the adapter (20) such that the electrically conductive element (30) is received within the adapter (20), the electrically conductive element (30) further comprising an electrically conducting connection contacting the housing (7, 8), the electrically conductive element (30) comprising a plate (31) that comprises a plurality of orifices from where the pins (21, 21.1) come out.

2. Vehicle imaging device, according to claim 1, wherein the housing (7, 8) comprises an opening (40) configured for the passage of at least the pin (21.1) comprising a ground connection out of the cavity (12) of the housing (7, 8), the electrically conductive element (30) being a planar surface element located such that at least partially covers the opening (40).

3. Vehicle imaging device, according to claim 1, wherein the adapter (20) comprises a surface (22) substantially perpendicular to the pin (21.1) comprising a ground connection and a lateral wall (23) that extends substantially perpendicular to said surface (22).

4. Vehicle imaging device, according to any preceding claim, wherein the electrically conductive element (30) comprises:
- the electrically conductive plate (31) located perpendicular to the pin (21.1) comprising a ground connection,
- a lateral wall (32) that extends substantially perpendicular to said plate (31), and
- a projection (9) extending outwardly from said lateral walls (32) being located such that it contacts the inner cavity (12) of the housing (7, 8).

5. Vehicle imaging device, according to claims 3 and 4, wherein the electrically conductive plate (31) extends until the lateral walls (23) of the adapter (20), substantially covering the surface (22).

6. Vehicle imaging device, according to claims 3 and 4, wherein the adapter (20) comprises an opening (24) in its lateral walls (23) being in correspondence with the projection (9) such that the projection (9) passes through the opening (24) for contacting the housing (7, 8).

7. Vehicle imaging device, according to any preceding claim 4 to 6, wherein the projection (9) is flexible and is configured to be bent to adapt its position to contact the housing (7, 8).

8. Vehicle imaging device, according to any preceding claim 4 to 7, wherein the projection (9) is configured to be bent in a direction perpendicular to the longitudinal direction of the pin (2.1) comprising a ground connection.

9. Vehicle imaging device, according to claim 3 and 4, wherein the projection (9) is configured to surpass the lateral wall (23) free edge of the adapter (20) such that it contacts the housing (7, 8).

10. Vehicle imaging device, according to any preceding claim 4 to 9, wherein the plate (31) of the electrically conductive element (30) comprises an orifice (34) where the pin (21.1) comprising a ground connection comes out, the orifice (34) being in electrical contact with the pin (21.1) comprising a ground connection.

## Patentansprüche

1. Fahrzeugbildgebungsvorrichtung, umfassend:
• einen Bildsensor (15), der zum Erfassen eines Bildes konfiguriert ist,
• eine Linse (1), die mit dem Bildsensor (15) in Verbindung steht und konfiguriert ist, einen Lichtstrahl in den Bildsensor (15) zu leiten,
• eine erste Leiterplatte (3) in Verbindung mit dem Bildsensor (15),
• einen Stift (21.1), der einen Masseanschluss umfasst und in elektrischer Verbindung mit der Leiterplatte (3) steht,
• ein Gehäuse (7, 8), das einen inneren Hohlraum (12) umfasst, der mindestens die Leiterplatte (3) umschließt, wobei der Bildsensor (15) und ein Teil des Stifts (21.1) einen Masseanschluss umfassen, wobei das Gehäuse (7, 8) in elektrischer Verbindung mit der Leiterplatte (3) steht,
• ein elektrisch leitfähiges Element (30), das in elektrischer Verbindung mit dem Stift (21.1) steht, der einen Masseanschluss umfasst, wobei das elektrisch leitfähige Element (30) in elektrischem Kontakt mit dem Gehäuse (7, 8) steht, so dass eine geschlossene elektrische Schleife zwischen der Leiterplatte (3) gebildet wird, wobei der Stift (21.1) einen Masseanschluss, das elektrisch leitfähige Element (30), das Gehäuse (7, 8) und die Leiterplatte (3) umfasst, und
• einen Adapter (20), wobei der Adapter (20) mindestens eine Vielzahl von Stiften (21) umfasst, einschließlich des Stifts (21.1), der einen Masseanschluss umfasst, wobei das elektrisch leitfähige Element (30) Teil des Adapters (20) ist oder daran befestigt ist, so dass das elektrisch leitfähige Element (30) innerhalb des Adapters (20) aufgenommen wird, wobei das elektrisch leitfähige Element (30) ferner eine elektrisch leitende Verbindung umfasst, die mit dem Gehäuse (7, 8) in Kontakt steht, wobei das elektrisch leitfähige Element (30) eine Platte (31) umfasst, die eine Vielzahl von Öffnungen umfasst, aus denen die Stifte (21, 21.1) heraustreten.

2. Fahrzeugbildgebungsvorrichtung nach Anspruch 1, wobei das Gehäuse (7, 8) eine Öffnung (40) umfasst, die für den Durchgang mindestens des Stifts (21.1) konfiguriert ist, der einen Masseanschluss aus dem Hohlraum (12) des Gehäuses (7, 8) umfasst, wobei das elektrisch leitfähige Element (30) ein planares Oberflächenelement ist, das so angeordnet ist, dass es die Öffnung (40) zumindest teilweise abdeckt.

3. Fahrzeugbildgebungsvorrichtung nach Anspruch 1, wobei der Adapter (20) eine Fläche (22) umfasst, die im Wesentlichen senkrecht zu dem Stift (21.1) ist und einen Masseanschluss und eine Seitenwand (23) umfasst, die sich im Wesentlichen senkrecht zu der Fläche (22) erstreckt.

4. Fahrzeugbildgebungsvorrichtung nach einem der vorstehenden Ansprüche, wobei das elektrisch leitfähige Element (30) umfasst:
- die elektrisch leitfähige Platte (31), die senkrecht zu dem Stift (21.1) angeordnet ist, einen Masseanschluss umfasst,
- eine Seitenwand (32), die sich im Wesentlichen senkrecht zur Platte (31) erstreckt, und
- einen Vorsprung (9), der sich von den Seitenwänden (32) nach außen erstreckt und so angeordnet ist, dass er mit dem inneren Hohlraum (12) des Gehäuses (7, 8) in Kontakt steht.

5. Fahrzeugbildgebungsvorrichtung nach Ansprüche 3 und 4, wobei sich die elektrisch leitfähige Platte (31) bis zu den Seitenwänden (23) des Adapters (20) erstreckt und im Wesentlichen die Oberfläche (22) bedeckt.

6. Fahrzeugbildgebungsvorrichtung nach Ansprüche 3 und 4, wobei der Adapter (20) eine Öffnung (24) in seinen Seitenwänden (23) umfasst, die dem Vorsprung (9) entspricht, so dass der Vorsprung (9) durch die Öffnung (24) hindurchgeht, um mit dem Gehäuses (7, 8) in Kontakt zu stehen.

7. Fahrzeugbildgebungsvorrichtung nach einem der vorstehenden Ansprüche 4 bis 6, wobei der Vorsprung (9) flexibel und konfiguriert ist, dass er gebogen werden kann, um seine Position anzupassen, damit er mit dem Gehäuse (7, 8) in Kontakt steht.

8. Fahrzeugbildgebungsvorrichtung nach einem der vorstehenden Ansprüche 4 bis 7, wobei der Vorsprung (9) konfiguriert ist, in einer Richtung senkrecht zur Längsrichtung des Stifts (2.1), der einen Masseanschluss umfasst, gebogen zu werden.

9. Fahrzeugbildgebungsvorrichtung nach Ansprüche 3 und 4, wobei der Vorsprung (9) konfiguriert ist, die freie Kante der Seitenwand (23) des Adapters (20) zu überragen, um mit dem Gehäuse (7, 8) in Kontakt zu stehen.

10. - Fahrzeugbildgebungsvorrichtung nach einem der vorstehenden Ansprüche 4 bis 9, wobei die Platte (31) des elektrisch leitfähigen Elements (30) eine Öffnung (34) umfasst, an der der Stift (21.1), der einen Masseanschluss umfasst, heraustritt, wobei die Öffnung (34) in elektrischem Kontakt mit dem Stift (21.1) steht, der einen Masseanschluss umfasst.

## Revendications

1. Dispositif d'imagerie de véhicule, comprenant :
• un capteur (15) d'image configuré pour capturer une image,
• une lentille (1) en communication avec le capteur (15) d'image et configurée pour guider un faisceau lumineux dans le capteur (15) d'image,
• une carte (3) de circuit imprimé en connexion avec le capteur (15) d'image,
• une broche (21.1) comprenant une connexion à la terre et en connexion électrique avec la carte (3) de circuit imprimé,
• un boîtier (7, 8) comprenant une cavité (12) interne renfermant au moins la carte (3) de circuit imprimé, le capteur (15) d'image et une partie de la broche (21.1) comprenant une connexion à la terre, dans lequel le boîtier (7, 8) est en connexion électrique avec la carte (3) de circuit imprimé,
• un élément (30) électriquement conducteur situé en connexion électrique avec la broche (21.1) comprenant une connexion à la terre, l'élément (30) électriquement conducteur étant en contact électrique avec le boîtier (7, 8), de telle sorte qu'une boucle électrique fermée est formée entre la carte (3) de circuit imprimé, la broche (21.1) comprenant une connexion à la terre, l'élément (30) électriquement conducteur, le boîtier (7, 8) et la carte (3) de circuit imprimé, et
• un adaptateur (20), ledit adaptateur (20) comprenant au moins une pluralité de broches (21) comprenant la broche (21.1) comprenant une connexion à la terre, l'élément (30) électriquement conducteur faisant partie de ou étant fixé à l'adaptateur (20), de telle sorte que l'élément (30) électriquement conducteur est reçu à l'intérieur de l'adaptateur (20), l'élément (30) électriquement conducteur comprenant en outre une connexion électriquement conductrice en contact avec le boîtier (7, 8), l'élément (30) électriquement conducteur comprenant une plaque (31) qui comprend une pluralité d'orifices à partir desquels les broches (21, 21.1) sortent.

2. Dispositif d'imagerie de véhicule selon la revendication 1, dans lequel le boîtier (7, 8) comprend une ouverture (40) configurée pour le passage d'au moins la broche (21.1) comprenant une connexion à la terre hors de la cavité (12) du boîtier (7, 8), l'élément (30) électriquement conducteur étant un élément de surface plan situé de telle sorte qu'il recouvre au moins partiellement l'ouverture (40).

3. Dispositif d'imagerie de véhicule selon la revendication 1, dans lequel l'adaptateur (20) comprend une surface (22) substantiellement perpendiculaire à la broche (21.1) comprenant une connexion à la terre et une paroi latérale (23) qui s'étend substantiellement perpendiculaire à ladite surface (22).

4. Dispositif d'imagerie de véhicule, selon l'une quelconque des revendications précédentes, dans lequel l'élément (30) électriquement conducteur comprend :
- la plaque (31) électriquement conductrice située perpendiculairement à la broche (21.1) comprenant une connexion à la terre,
- une paroi (32) latérale qui s'étend substantiellement perpendiculairement à ladite plaque (31), et
- une saillie (9) s'étendant vers l'extérieur à partir desdites parois (32) latérales, étant située de telle sorte qu'elle entre en contact avec la cavité (12) interne du boîtier (7, 8).

5. Dispositif d'imagerie de véhicule selon les revendications 3 et 4, dans lequel la plaque (31) électriquement conductrice s'étend jusqu'aux parois latérales (23) de l'adaptateur (20), recouvrant substantiellement la surface (22).

6. Dispositif d'imagerie de véhicule selon les revendications 3 et 4, dans lequel l'adaptateur (20) comprend une ouverture (24) dans ses parois (23) latérales en correspondance avec la saillie (9), de sorte que la saillie (9) passe à travers l'ouverture (24) pour entrer en contact avec le boîtier (7, 8).

7. Dispositif d'imagerie de véhicule selon la revendication 6, dans lequel la saillie (9) est flexible et est configurée pour être pliée afin d'adapter sa position pour entrer en contact avec le boîtier (7, 8).

8. Dispositif d'imagerie de véhicule selon l'une quelconque des revendications 4 à 7, dans lequel la saillie (9) est configurée pour être pliée dans une direction perpendiculaire à la direction longitudinale de la broche (2.1) comprenant une connexion à la terre.

9. Dispositif d'imagerie de véhicule selon les revendications 3 et 4, dans lequel la saillie (9) est configurée pour dépasser le bord libre de la paroi latérale (23) de l'adaptateur (20), de telle sorte qu'elle entre en contact avec le boîtier (7, 8).

10. Dispositif d'imagerie de véhicule selon l'une quelconque des revendications 4 à 9, dans lequel la plaque (31) de l'élément (30) électriquement conducteur comprend un orifice (34) où sort la broche (21.1) comprenant une connexion à la terre, l'orifice (34) étant en contact électrique avec la broche (21.1) comprenant une connexion à la terre.
